# EUROPEAN PATENT APPLICATION

(11) **EP 4 576 205 A1**
(43) Date of publication of application: **25.06.2025**
(21) Application number: 24220693.6
(22) Date of filing: 17.12.2024
(51) Int. Cl.: H01L 23/495, H01L 21/48

(54) **SEMICONDUCTOR CHIP PACKAGING DEFECT FREE DIMPLE PROCESS AND DEVICE**

(30) Priority: 22.12.2023 US 202318394364
(71) Applicant: NXP B.V., 5656 AG Eindhoven (NL)
(72) Inventor: SUWANKASAB, Chanon, 5656AG Eindhoven (NL); SAIYAJITARA, Amornthep, 5656AG Eindhoven (NL); PAIRPISIT, Kornteenee, 5656AG Eindhoven (NL)
(74) Representative: Krott, Michel

(57) **Abstract**

Embodiments of the subject matter described herein relate semiconductor chip packages, and more specifically, to Quad Flat No-Lead (QFN) burr free dimple packages, Small Outline No-lead (SON) burr free and defect free dimple packages, and a process scheme for producing a burr free dimple after singulation without additional deburring processes.

## Description

### TECHNICAL FIELD

Embodiments of the subject matter described herein relate semiconductor chip packages, and more specifically, to Quad Flat No-Lead (QFN) burr free dimple packages, Small Outline No-lead (SON) burr free and defect free dimple packages, and a process scheme for producing a burr free dimple after singulation without additional deburring processes.

### BACKGROUND

Quad Flat No-Lead (QFN) and Small Outline None Lead (SON) packages are used to encapsulate one or more integrated circuit die while retaining exposed pads which physically and electrically connect integrated circuit die to printed circuit boards (PCB). These QFN and SON packages are surface-mount technologies that connect integrated circuit dies to the surfaces of PCBs without through-holes using perimeter lead pads on the bottom of the package to provide electrical contact to the PCB. Conventional QFN and SON packaging approaches have performed and result with dimple burr after singulation. The dimple burr is typically caused after cutting.

In the related art, during the singulation or saw processes burrs are prone to accumulate in the dimple. If the accumulation is sufficient and the burrs are not removed, there is a possibility the burrs could impact the solder joint reliability of the device. Removing these burrs requires extra process steps and is difficult, time consuming, and costly. In addition, fine pitch QFN and SON packages, e.g., less than 1.0 mm are more prone to burr accumulation and deburring process may also not be possible given their geometric complexity which can result in not using dimples for semiconductor packages.

Accordingly, a need exists for an improved integrated circuit chip package and manufacture method that addresses various problems in the art that have been discovered by the above-named inventors where various limitations and disadvantages of conventional solutions and technologies will become apparent to one of skill in the art after reviewing the remainder of the present application with reference to the drawings and detailed description which follow, though it should be understood that this description of the related art section is not intended to serve as an admission that the described subject matter is prior art.

### SUMMARY

An aspect of the invention is directed to semiconductor chip packages, and more specifically, to Quad Flat No-Lead (QFN) burr free dimple packages, Small Outline No-lead (SON) defect free packages with dimples after the singulation process or other separating process. In one process scheme a semiconductor package includes a burr free dimple after singulation without the need for additional deburring processes.

Additional features and advantages of the invention will be set forth in the description which follows and, in part, will be apparent from the description or may be learned by practice of the invention. The objectives and other advantages of the invention will be realized and attained by the structure, particularly set forth in the written description and claims hereof, as well as the appended drawings.

In some aspects, the techniques described herein relate to a semiconductor package, including a lead frame having a plurality of leads. The package also includes a semiconductor die mounted on the lead frame. Bonding pads on the die are electrically connected to ones of the leads and a mold compound encapsulates the die. The leads and the electrical connections are exposed at corner side wall of the semiconductor package, and an exposed portion of each of the leads is flush with two adjacent sides of the device. A portion of the leads a dimple being partially filed or containing a polymer material arranged in a portion of the dimple. The polymer material is configured to prevent defects, e.g., burrs, smearing and other defects during the singulation process.

In some aspects, the techniques described herein the polymer material includes a material formed to about twenty microns or greater in thickness.

In some aspects, the techniques described herein the polymer material includes a material selected from the group consisting of polyimide, polyacrylate, and silicone. The polymer material can also be a thermoplastic polymer and a thermoset polymer.

This Summary section is neither intended to be nor should be construed as being representative of the full extent and scope of the present disclosure. Additional benefits, features and embodiments of the present disclosure are set forth in the attached figures and in the description hereinbelow, and as described by the claims. Accordingly, it should be understood that this Summary section may not contain all of the aspects and embodiments claimed herein.

Additionally, the disclosure herein is not meant to be limiting or restrictive in any manner. Moreover, the present disclosure is intended to provide an understanding to those of ordinary skill in the art of one or more representative embodiments supporting the claims. Thus, it is important that the claims be regarded as having a scope including constructions of various features of the present disclosure insofar as they do not depart from the scope of the methods and apparatuses consistent with the present disclosure (including the originally filed claims). Moreover, the present disclosure is intended to encompass and include obvious improvements and modifications of the present disclosure.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a perspective view of a semiconductor package device with burr free dimples in accordance with an embodiment.
FIG. 2 is a cross sectional view of the semiconductor package device of FIG. 1 along line 1-1 prior to singulation, in accordance with an embodiment.
FIG. 3 is a cross sectional view of the device of FIG. 1 along line 1-1 after singulation, in accordance with an embodiment.
FIG. 4 is a flowchart of a method of fabricating the device of FIG. 1, according to an embodiment.
FIGS. 5-9 display a simplified cross-sectional views of a series of fabrication steps for forming the device of FIG. 1, according to an embodiment.
FIG. 10 is a perspective view of a semiconductor package device with burr free dimples in accordance with another embodiment.

### DETAILED DESCRIPTION

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or the following detailed description.

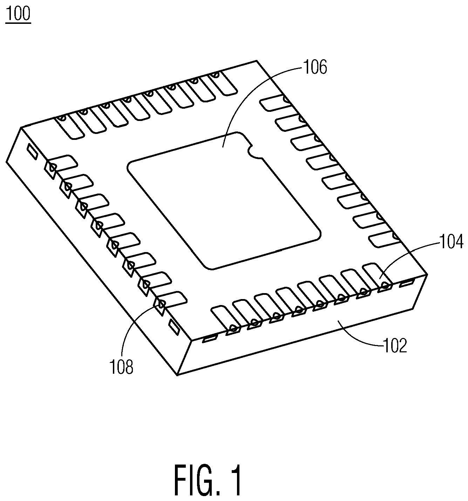

FIG. 1 is a perspective view of a semiconductor package device with burr free dimples in accordance with an embodiment.

Referring to FIG. 1, the semiconductor package 100 is a QFN package having a generally square or rectangular shape and being small. For example, in one embodiment the semiconductor package 100 is on the order of 0.6 mm x 0.6 mm (LxW) or smaller. The package includes a body 102, leads 104 and a thermal pad 106. The leads 104 are flush with the bottom and side surfaces of the package 100. The leads 104 include burr free dimples 108. The burr free dimples 108 can be used as an enhancement feature for formation of wettable flanks, e.g., configured to meet predetermined lead pitch criteria, closer geometries, and the like. Unlike in the related art the dimples 108 are free burrs without an additional process step of de-burring to remove burrs or other defects formed during a singulation process.

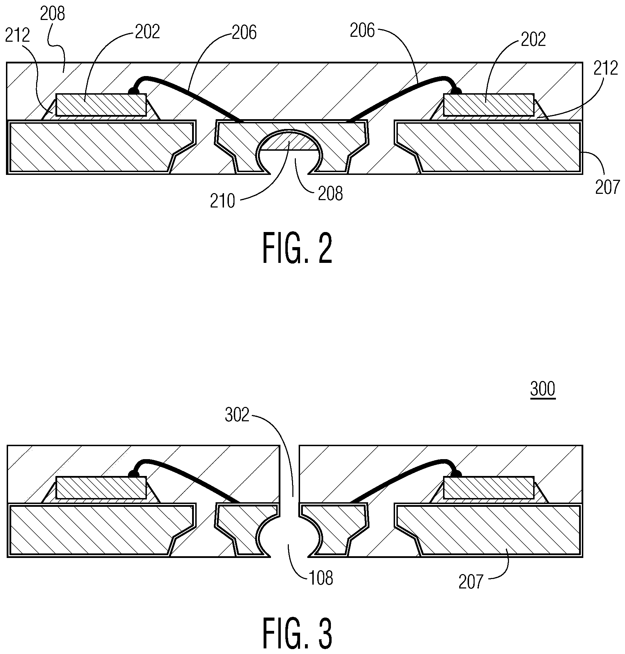

FIG. 2 is a cross sectional view of the semiconductor package device of FIG. prior to singulation, in accordance with an embodiment.

Referring to FIG. 2, the QFN semiconductor package 100 includes semiconductor dies 202 that are electrically connected to leads 204 with bond wires 206. The semiconductor dies 202 are attached to the body 212 with a die attach material 214. The leads include a dimple 208 prior to a singulation process. The dies 202, portions of leads 204, and bond wires 206, plating 207 are encapsulated by the mold compound 208. The plating 207 can be a metal material or alloy material, e.g., Ni, Pd, AuAg/Au materials, combinations of the same and the like. A polymer material 210 is formed in portion of the dimple 208 before a singulation or cutting process. The polymer material 210 can include a thermoplastic material, thermoset material, e.g., a polyimide material, polyacrylate material, silicone material combinations of the same and the like. The polymer material can have a thickness of 20 microns or greater.

FIG. 3 is a cross sectional view of the device of FIG. 1 along line 1-1 after singulation, in accordance with an embodiment.

Referring to FIG. 3, the semiconductor package 100 includes a burr free dimple 108 after the singulation process, e.g., sawing or cutting process. That is, the dimple after the singulation process is formed without any accumulation of burrs and is burr free and also the singulation process is does not include a deburring process, e.g., etching, or other chemical deburring process. The dimple 108 without burrs or metal smear accumulation of defects or other defects, *e.g.,* no defects including burrs, metal smear or other defects are generated during the singulation process.

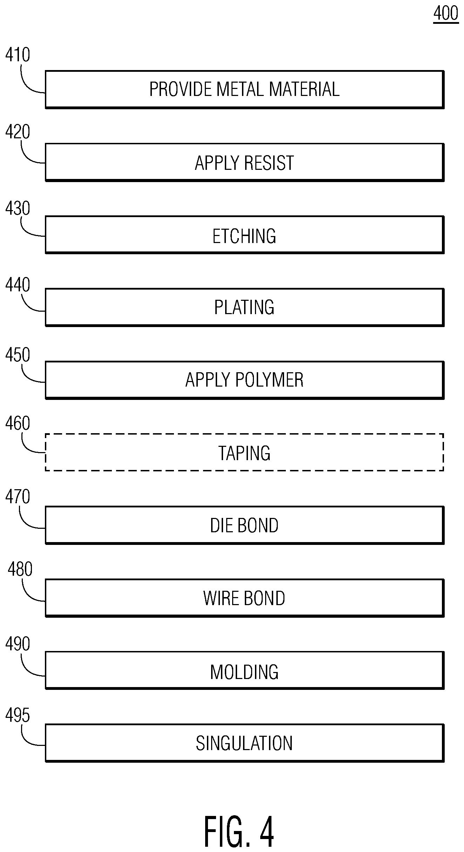

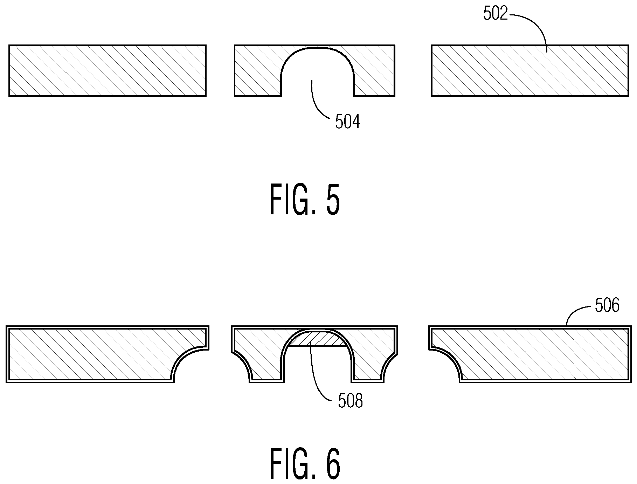

FIG. 4 is a flowchart of a method of fabricating the device of FIG. 1, according to an embodiment. FIG. 4 may be best understood by simultaneously the steps of FIG. 4 while viewing FIGS. 5-9.

Referring to FIG. 4, illustrating a semiconductor package process flow 400 for forming a semiconductor package, *e.g.,* a QFN dimple burr free package, SON package. The process flow 400 does not include additional deburring process steps, e.g., chemical deburr process. In step 410, a sheet of conductive metal, e.g., copper, or other conductive metal, is provided. The lead frame can include an array of lead frames. In step 420, a resist is applied to the metal sheet. In step 430, the metal sheet is etched by etching or other process to form one or lead frames 502, *e.g.,* an array of lead frame, and dimples 504 are also formed.

In step 440, after dimples are formed plating 506 is formed on the lead frame 502 and dimples 504 or only selected portions thereof, as desired. The plating step 440 preferably is performed using an electro-plating or electro-deposition process during which the lead frames including the ends or edges of the leads are coated with a solderable layer of plating material described herein, *e.g.,* Ni/Pd/AuAg/Au materials, curing the plating process, the leads may be connected to a source of electrical potential so that they will form a cathode during the electro-plating or electro-deposition process. The electro-plating or electro-deposition process results in a conductive, wettable metal layer being deposited onto the exposed surfaces of the lead frame. It should be noted that the lead frame may include bare copper or the lead frame may be pre-plated such as with silver at the bond surface (back side typically remains as bare copper) and a coating of tin or tin alloy may be applied to the exposed lead ends before or after cutting the lead frame into individual semiconductor devices.

In step 450, a polymer material 508 is formed in at least a portion of the dimple 504. The polymer material 508 can include a thermoplastic material, thermoset material, e.g., a polyimide material, polyacrylate material, silicone material combinations of the same and the like. In a preferred embodiment, the polymer material 508 can have a thickness of 20 microns or greater. The polymer material 508 can be formed by dispensing, screen printing, pasting, combinations of the same and the like.

Step 460 is an optional taping step, the lead frame or lead frame array 502 is taped with a layer of tape 510 applied the backside of the lead frame. The tape 510 is configured to prevent the lead frames 502 from being deformed prior to use.

Step 470, a die 520 is mounted on and attached to the leads of a lead frame, such as the lead frames. In a presently preferred embodiment, the corners of the non-active side of the die rest on and are attached to inner portions of the leads. A die attach adhesive or double-sided tape 522 may be used to attach the die 522 to the leads.

Step 480 is a wire bonding step, where die bonding pads are electrically connected to respective ones of the leads with bond wires. In an alternative embodiment, the die may be a flip-chip die and have solder bumps on the die bond pads and then the die is mounted on the lead frame with the die active side facing the lead frame such that the die bond pads are in direct contact with the leads.

In step 490, a wire bonding step is followed by an encapsulation or molding step in which the lead frame, die and bond wires are covered with a mold compound 522, as is known in art. The molding step preferably includes a mold array process (MAP) where several assemblies formed on a lead frame array are all molded at the same time. After the molding step, laser marking is performed and if there is a tape on the bottom surface of the lead frame array, then the tape is removed in a de-taping step.

In step 495, the assemblies are separated from each other in a singulation step in which a saw blade cuts and separates the assembled devices from each other. The polymer material 508 prevents any accumulation of burrs or other defects of the plating 506. Thereby preventing the need for further deburring or processing.

FIGS. 5-9 display simplified cross sectional views of a series of fabrication steps for forming the device of FIG. 1, according to an embodiment.

Referring to FIG. 5-9, displaying simplified cross-sectional views of a series of fabrication steps 410-495 for semiconductor package 100 of FIG. 1, according to an embodiment.

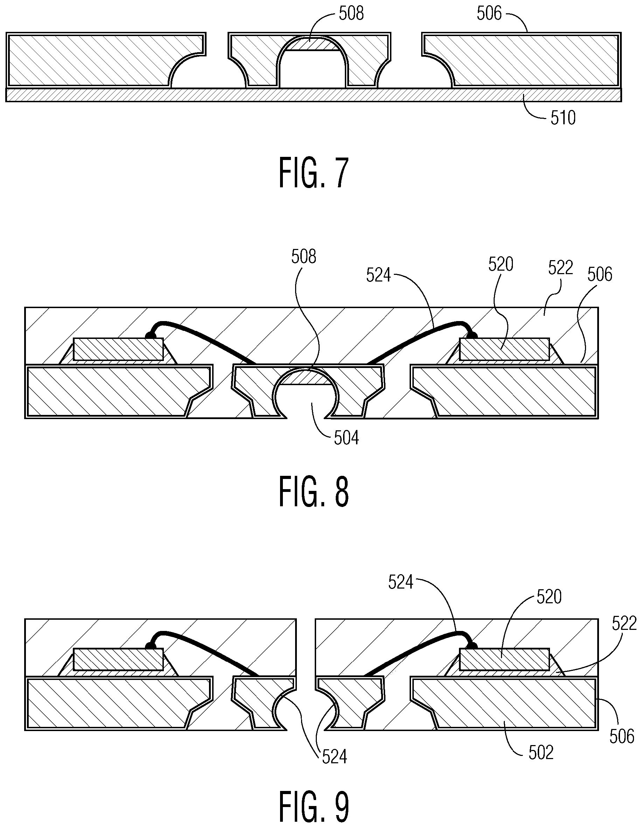

Referring to FIG. 5, a lead frame 502 includes an array of lead frames with a dimple 504. In FIG. 6, a polymer material 508 is arranged in a dimple 508 after a plating 506 has been formed as described herein with respect to FIG. 4. The polymer material 508 is utilized to prevent burrs, smearing, and other defects from forming on the plating 506 during a singulation process. In a preferred embodiment, the polymer material 508 is formed in at least a portion of the dimple 504 to a thickness of 20 microns or greater. The polymer material 508 can include a thermoplastic material, thermoset material, e.g., a polyimide material, polyacrylate material, silicone material, combinations of the same and the like. FIG. 7 shows an optional step 460, where tape 510 is provided on lead frame or lead frame array.

Referring to FIG. 8, a die 520 is attached with is mounted on and attached to the leads of a lead frame, such as the lead frames with bonding material 522, wire bonding, where die bonding pads are electrically connected to respective ones of the leads with bond wires 524. In FIG. 9, the assemblies have been separated from each other in a singulation step 495. The polymer material 508 prevents any accumulation of burrs, smearing, or other defects of the plating 506, thereby a burr free or defect free dimple 524 is shown (FIG. 1).

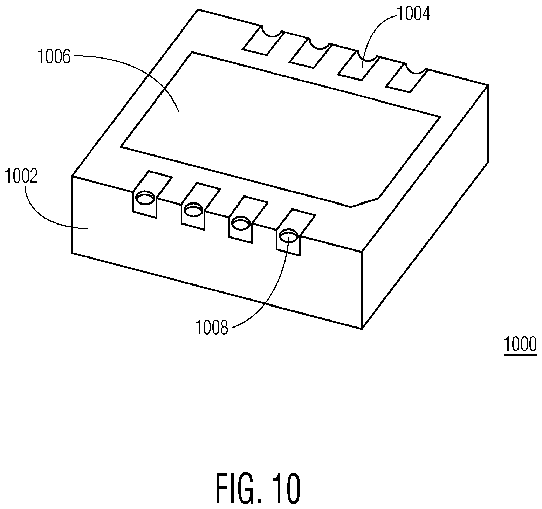

FIG. 10 is a perspective view of a semiconductor package device with burr free dimples in accordance with another embodiment. Referring to FIG. 10, a process as described with reference to FIG. 4 can also be utilized to form a burr free or defect free dimple without additional deburring process steps. FIG. 10 includes a SON semiconductor having a generally square or rectangular shape and being small. For example, in one embodiment the semiconductor package 100 is on the order of 0.6 mm x 0.6 mm (LxW) or smaller. The package includes a body 1002, leads 1004 and a thermal pad 1006. The leads 1004 include burr free dimples 1008. The burr free dimples 1008 can be used as an enhancement feature for formation of wettable flanks, e.g., configured to meet predetermined lead pitch criteria, closer geometries, and the like. Unlike in the related art the dimples 1008 are free burrs, smear, or other defects without an additional process step of de-burring to remove burrs or other defects formed during a singulation process.

In some aspects, the techniques described herein relate to a method of forming to lead frame for a semiconductor package, including: providing a sheet of conductive material; applying a resist material in a predetermined pattern on the sheet of conductive material; etching the conductive material to form a lead frame that has leads that extend to corners of the lead frame such that each corner lead has a dimple formed at an outer surface thereof; applying a metal or metal alloy to exposed lead ends of the leads; and applying a polymer material into a portion of the dimple to a predetermined thickness.

In some aspects, the techniques described herein relate to a method, wherein the metal or metal alloy is applied by electro-plating or electro-deposition.

In some aspects, the techniques described herein relate to a method, wherein the predetermined thickness is 20 microns or greater.

In some aspects, the techniques described herein relate to a method, wherein the metal or metal alloy includes one or more of NiPdAu, NiPdAuAg, and NiPd.

In some aspects, the techniques described herein relate to a method, further including applying tape to portion the lead frame.

In some aspects, the techniques described herein relate to a method, wherein the polymer material includes a thermoplastic material.

In some aspects, the techniques described herein relate to a method, wherein the polymer material includes a material selected from the group consisting of thermoplastic polymer and a thermoset polymer.

In some aspects, the techniques described herein relate to a method, wherein the polymer material includes a material selected from the group consisting of polyimide, polyacrylate, and silicone.

In some aspects, the techniques described herein relate to a method, further includes cutting the lead frame through a portion of the dimple and the polymer material, wherein the dimple of each corner lead has no burrs or defects immediately after cutting.

In some aspects, the techniques described herein relate to a method of forming semiconductor packaging with a burr free dimple, including: providing an array of rectangular lead frames, wherein each lead frame of the array of rectangular lead frames has leads that extend to corners of each lead frame and a dimple at an outer surface thereof; applying a metal or metal alloy to exposed lead ends of the leads; applying a polymer material in a portion of dimple, wherein the polymer material is configured to prevent accumulation of defects including one or more of burrs; mounting and attaching semiconductor dies to the lead frames; electrically connecting bond pads on the semiconductor dies with each semiconductor die on a different one of the leads of the lead frames upon which the semiconductor dies are mounted; and encapsulating the semiconductor dies and electrical connections with a mold compound; and cutting the array of lead frames to separate individual devices from adjacent devices through a portion of the dimple and polymer material, whereby each device has corner bond pads that are configured to be substantially flush with the mold compound thereof and wherein the dimple of each corner lead has no burrs or defects immediately after cutting.

In some aspects, the techniques described herein relate to a method, wherein the metal or alloy is applied by electro-plating or electro-deposition.

In some aspects, the techniques described herein relate to a method, wherein the metal or metal alloy includes one or more of NiPdAu, NiPdAuAg, and NiPd.

In some aspects, the techniques described herein relate to a method, wherein the step of electrically connecting includes attaching bond wires to the die bond pads and respective ones of the leads.

In some aspects, the techniques described herein relate to a method, wherein non-active sides of the semiconductor dies are attached to the leads of each of the respective lead frames.

In some aspects, the techniques described herein relate to a method, wherein the polymer material includes a thermoplastic material.

In some aspects, the techniques described herein relate to a method, wherein the polymer material includes a material selected from the group consisting of thermoplastic polymer and a thermoset polymer.

In some aspects, the techniques described herein relate to a method, wherein the polymer material includes a material selected from the group consisting of polyimide, polyacrylate, and silicone.

In some aspects, the techniques described herein relate to a method, wherein the polymer material includes a material formed to about twenty microns or greater in thickness.

In some aspects, the techniques described herein relate to a semiconductor package, including: a lead frame including a plurality of leads; a semiconductor die mounted on the lead frame, wherein bonding pads on the semiconductor die are electrically connected to respective ones of the leads; and a mold compound that encapsulates the semiconductor die, the leads, and electrical connections, wherein ends of the leads are exposed at corner side wall of the semiconductor package, and wherein an exposed portion of each of the leads is flush with two adjacent sides of a device and includes a dimple including a polymer material arranged in a portion of the dimple.

In some aspects, the techniques described herein relate to a semiconductor package, wherein the polymer material includes a material selected from the group consisting of thermoplastic polymer and a thermoset polymer.

For the sake of brevity, conventional semiconductor fabrication techniques may not be described in detail herein. In addition, certain terminology may also be used herein for the purpose of reference only, and thus are not intended to be limiting, and the terms "first," "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A method of forming to lead frame for a semiconductor package, comprising:
providing a sheet of conductive material;
applying a resist material in a predetermined pattern on the sheet of conductive material;
etching the conductive material to form a lead frame that has leads that extend to corners of the lead frame such that each corner lead has a dimple formed at an outer surface thereof;
applying a metal or metal alloy to exposed lead ends of the leads; and
applying a polymer material into a portion of the dimple to a predetermined thickness.

2. The method of claim 1, wherein the metal or metal alloy is applied by electro-plating or electro-deposition.

3. The method of claim 1 or 2, wherein the predetermined thickness is 20 microns or greater.

4. The method of any preceding claim, wherein the metal or metal alloy comprises one or more of NiPdAu, NiPdAuAg, and NiPd.

5. The method of any preceding claim, further comprising applying tape to portion the lead frame.

6. The method of any preceding claim, wherein the polymer material comprises a thermoplastic material.

7. The method of any preceding claim, wherein the polymer material comprises a material selected from the group consisting of thermoplastic polymer and a thermoset polymer.

8. The method of any preceding claim, wherein the polymer material comprises a material selected from the group consisting of polyimide, polyacrylate, and silicone.

9. The method of any preceding claim, further comprises cutting the lead frame through a portion of the dimple and the polymer material, wherein the dimple of each corner lead has no burrs or defects immediately after cutting.

10. A semiconductor package, comprising:
a lead frame including a plurality of leads;
a semiconductor die mounted on the lead frame, wherein bonding pads on the semiconductor die are electrically connected to respective ones of the leads; and
a mold compound that encapsulates the semiconductor die, the leads, and electrical connections, wherein ends of the leads are exposed at corner side wall of the semiconductor package, and
wherein an exposed portion of each of the leads is flush with two adjacent sides of a device and includes a dimple comprising a polymer material arranged in a portion of the dimple.

11. The semiconductor package of claim 10, wherein the polymer material comprises a material selected from the group consisting of thermoplastic polymer and a thermoset polymer.
